# EUROPEAN PATENT SPECIFICATION

(11) **EP 0 671 851 B1**
(45) Date of publication and mention of the grant of the patent: **19.06.2002**
(21) Application number: 95301521.1
(22) Date of filing: 08.03.1995
(51) Int. Cl.: H04N 5/50, H03J 1/00

(54) **Tuning circuit for a television receiver**
Abstimmschaltung für ein Fernsehempfänger
Circuit d'accord pour un récepteur de télévision

(30) Priority: 11.03.1994 JP 4124594
(43) Date of publication of application: 13.09.1995
(73) Proprietor: MATSUSHITA ELECTRIC INDUSTRIAL CO., LTD., Kadoma-shi, Osaka 571-8501 (JP)
(72) Inventor: Sasabe, Tohru, Suita-shi, Osaka 565 (JP)
(74) Representative: Crawford, Andrew Birkby

(56) References cited:
- US-A- 4 385 315
- PATENT ABSTRACTS OF JAPAN vol. 016, no. 517 (E-1284), 23 October 1992 & JP-A-04 192976 (SHARP CORP), 13 July 1992,
- PATENT ABSTRACTS OF JAPAN vol. 011, no. 070 (E-485), 3 March 1987 & JP-A-61 227484 (SONY CORP), 9 October 1986,

## Description

The present invention relates to a tuning circuit for specifying an optimum tuning point by presence or absence of synchronous signal, in a television broadcast receiving system utilising a frequency synthesizer channel selection method.

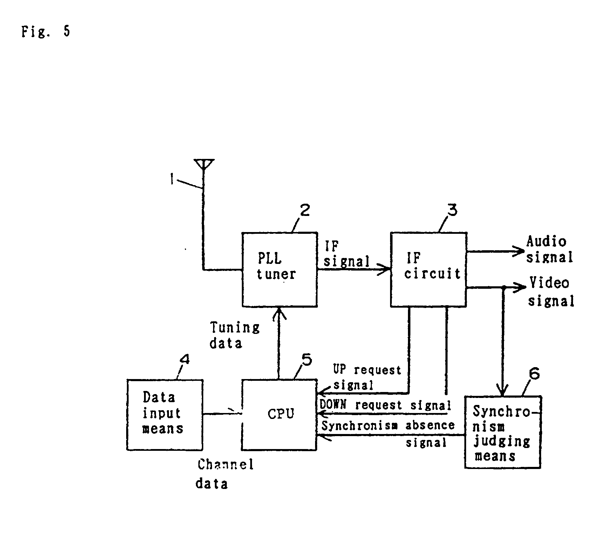

For example, Japanese Laid-Open Patent 4-192976 discloses one conventional television receiving system using a frequency synthesizer channel selection method. In this prior art document, a search algorithm is divided into a plurality of search regions in every channel, and a method of efficient retrieval of optimum local oscillation frequency is proposed. A schematic block diagram of this method is shown in Fig. 5. In Fig. 5, reference numeral 1 is a receiving antenna, 2 is a phase locked loop (PLL) tuner incorporating a local oscillation circuit, 3 is an IF circuit incorporating an automatic fine tuning (AFT) circuit, 4 is data input means, 5 is a central processing unit (CPU), and 6 is a synchronism judging circuit. The illustrations and descriptions present in the published prior art but not related with the present invention are omitted. Besides, even if not mentioned in the publication, any features known as prior art are additionally described.

A high frequency video signal received by the receiving antenna 1 is fed into the PLL tuner 2. The PLL tuner 2 incorporates a local oscillation circuit for generating a frequency depending on the tuning data from the CPU 5, and the local oscillation signal and the received high frequency video signal are mixed, thereby generating an intermediate frequency (IF) signal at a frequency resulting from substracting the high frequency video signal frequency from the local oscillation frequency, and it is sent out to the IF circuit 3.

In the IF circuit 3, by detecting a high frequency video signal of a channel of a certain specific frequency, a video signal and an audio signal are extracted. In the IF circuit 3, an AFT voltage is generated, and from this AFT voltage, an UP request signal and DOWN request signal are created and supplied into the CPU 5.

The UP request signal indicates a request to raise the local oscillation frequency of the local oscillation circuit of the PLL tuner 2, and the DOWN request signal indicates a request to lower the local oscillation frequency.

The synchronism judging circuit 6 judges if a horizontal sync signal is contained or not in the video signal from the IF circuit 3. A synchronism presence signal (L level) is sent out to the CPU 5 if a horizontal sync signal is contained, and a synchronism absence signal (H level) if not.

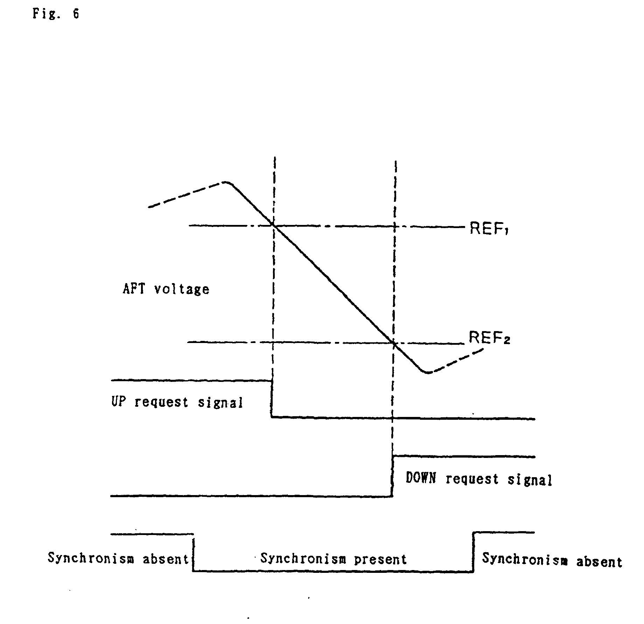

Fig. 6 shows the relation between the AFT signal, the sync signal, the UP request signal and the DOWN request signal. The CPU 5 controls the tuning data so as to obtain a local oscillation frequency capable of correctly receiving the broadcast channel (hereinafter optimum local oscillation frequency) selected depending on the information of the synchronism presence signal, UP request signal and DOWN request signal.

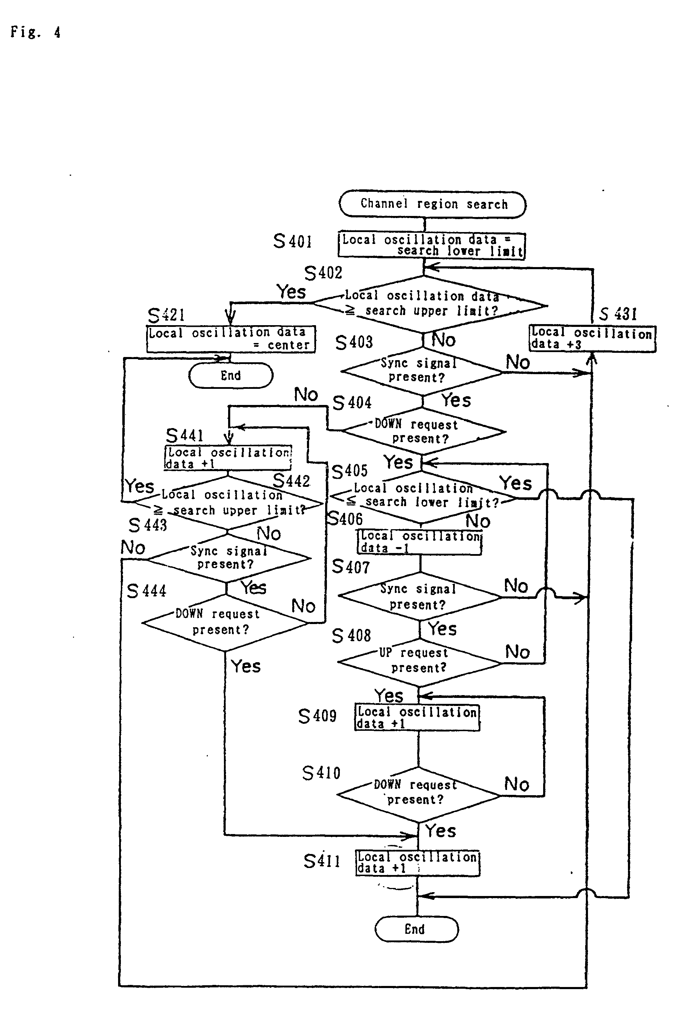

The channel selection operation by the CPU 5 is executed according to the flow chart in Fig. 4. The flow chart in Fig. 4 is also common to the embodiment of the invention described later. The flow chart in Fig. 4 is described below.

At step S401, the local oscillation frequency data is set at the search lower limit value of a selected channel.

At step S402, it is judged whether the local oscillation frequency data has exceeded the search upper limit value of the channel or not, thereby advancing to step S403 if the upper limit value is exceeded, or to step S421 if it is not exceeded.

Step S421 is a process of setting the local oscillation frequency data to the center value of the channel if the optimum local oscillation frequency is not found by searching up to the upper limit of the channel. At step S403, the presence or absence of a sync signal is judged. Processing goes to step S431 if the sync signal is absent, and to step S404 if present.

Step S431 is a high speed search process for raising the local oscillation frequency data by three steps. At step S404, the presence or absence of a DOWN request signal is judged. Processing goes to step S405 if a DOWN request signal is present, and to step S441 if absent.

At step S405, it is judged if the local oscillation frequency data is smaller than the lower limit value of the channel or not. If smaller, processing of the channel region search is terminated. If larger, processing advances to step S406 and, the local oscillation frequency data is lowered by one step.

At step S407, the presence or absence of a sync signal is judged. Processing advances to step S408 if a sync signal is present, and jumps to step S431 if absent.

Step S408 is for judging the presence or absence of an UP request signal. If an UP request signal is present, the local oscillation frequency data is raised by one step at step S409, and if absent, processing returns to step S405.

Step S410 is for judging the presence or absence of a DOWN request signal. If a DOWN request signal is present, processing advances to step S411 and the local oscillation frequency data is lowered by one step. Channel region search is then terminated. If absent, processing returns to step S409.

Returning to step S404, if the DOWN request signal is judged to be absent, the local oscillation frequency data is raised by one step at step S441. Step S442 is for judging if the local oscillation frequency data has exceeded the upper limit of channel search or not. If the upper limit is exceeded, processing of channel region search is terminated. If it is not exceeded, step S443 is processed.

Step S443 is for judging the presence or absence of a sync signal. If a sync signal is present, step S444 is processed, and if absent, processing jumps to step S431. Step S444 is for judging the presence or absence of a DOWN request signal. If there is a DOWN request signal, processing jumps to step S411, where the local oscillation frequency data is lowered by one step, and processing of the channel region search is terminated. If absent, step S441 is processed again.

Thus, in the flow chart shown in Fig. 4, first the local oscillation frequency data is set at the lower limit value of channel search region, and if a sync signal is absent, the point having a sync signal is searched for up to the upper limit value of the channel search region while raising the local oscillation frequency data by three steps each. If a sync signal is present, the optimum local oscillation frequency is set according to an UP request signal and a DOWN request signal, and presence of a sync signal is confirmed again, and the search process is terminated.

If a sync signal is not found after searching up to the upper limit of channel search region, the local oscillation frequency data is set in the center value of that channel, and processing is terminated.

Such prior art arrangement involves the following problems. In a channel search operation, if the optimum local oscillation frequency is set on the basis of the information of an UP request signal and a DOWN request signal by judging if a sync signal is present, the channel search operation is terminated. If a stable judging result of sync signal is not obtained from the synchronism judging circuit 6 after termination of channel selection, as is clear from the flow chart in Fig. 4., if the sync signal is changed from present to absent at the end of channel search operation, the search operation remains stopped.

Such a state may occur fairly often, considering the possibility of use of various performance in the synchronism judging circuit 6, or a transient state immediately after channel selection. Moreover, unless the result obtained in the synchronism judging circuit does not have an absolute response and stability for channel search operation, channel selection performance is not guaranteed.

Another example for a tuning circuit is disclosed in U.S.-A-4,385,315 where a phase locked loop PLL tuning control system for a voltage controlled oscillator is used. An AFT voltage is selectively applied to the local oscillator after a PLL configuration has obtained lock at the nominal frequency value for the selected channel so as to accommodate frequency translated RF carriers. An AFT control circuit is selectively activated by the average level of composite synchronization pulses indicative of an improper tuning condition caused by certain translated carrier clamps the AFT voltage at a predetermined level.

The predetermined level is selected to force the local oscillator frequency to be driven to an offset value at which an offset detector causes reinitiation of PLL control at discrete frequency step for the nominal value for the selected channel so as to properly tune the translated carrier.

A timed switching arrangement only allows the AFT control circuit to operate for a predetermined time after a new channel is selected so that channels, such as music channels, which do not provide synchronization pulses, can be tuned.

The timed switching arrangement is designed to avoid a problem unable to detect a synchronism signal in specific channel such as music channel that has a modulated sound carrier but does not have a modulated picture carrier.

### SUMMARY OF THE INVENTION

It is hence an object of the present invention to present a tuning circuit capable of performing optimum channel search even if a sync signal is unstable.

The present invention provides a tuning circuit, for use in a television receiving system having a frequency synthesizer channel selector, the circuit comprising:
a PLL tuner incorporating a local oscillation circuit,
an intermediate frequency circuit incorporating an auto-fine tuning (AFT) circuit, for generating an UP request signal or a DOWN request signal corresponding to an AFT voltage,
data input means for use by a user to select the channel,
synchronism judging means for judging if there is a sync signal or not in the video signals of the output of the intermediate frequency circuit, and generating a synchronism judging signal,
timer means for generating a timer ON signal only while counting within a specific period of time, and
control means responsive to selection of a new channel for operating a search operation within the channel frequency region by sending tuning data to the PLL tuner and sending timer controlling signals to the timer means;
characterized that;
the control means starts up a tuning control main loop, which is executed repeatedly within the specific period of time, receiving an UP request signal or a DOWN request signal from the IF circuit, the synchronism judging signal from the synchronism judging means and the timer ON signal from the timer means, and for sending tuning data to the PLL tuner to perform a search operation within the channel frequency region, and
the control means is arranged to monitor the synchronism judging signal from the synchronism judging means upon every start of the main loop during the operation of the timer means, and performs a search operation within the channel frequency region when the synchronism judging signal is absent during the presence of the timer ON signal.

In this arrangement, the control means starts counting the specific time of the timer means immediately after changeover of the channel selection, and monitors the synchronism judging signal from the synchronism judging means upon every start of the main loop during counting of the timer means. The control means performs window AFT processing when there is a synchronism judging signal during the presence of a timer ON signal.

The control means further checks the synchronism judging signal by setting the local oscillation frequency data to the center value of the selected channel right after channel changeover, and performs window AFT processing immediately when the synchronism judging signal is present.

Moreover, the control means also checks the synchronism judging signal by setting the local oscillation frequency data to the center value of the selected channel immediately after channel changeover, and performs a channel search operation immediately the synchronism judging signal is absent.

That is, the invention is characterised by starting the timer means for counting specific time immediately after channel selection, and starting the channel search operation again when the sync signal disappears within a specific period of time.

In this arrangement, even if the performance of the synchronism judging circuit is poor, the channel search operation is guaranteed. In this case, the time setting can be arbitrarily changed in order to assure the performance of the channel search operation depending on the application.

In order that the present invention be more readily understood, an embodiment thereof will now be described by way of example, in which:-

### BRIEF DESCRIPTION OF THE DRAWINGS

Fig. 1 is a structural block diagram of tuning circuit in an embodiment of the invention.

Fig. 2 is a flow chart of tuning control process in the embodiment.

Fig. 3 is a flow chart of window AFT processing in tuning control processing in Fig. 2.

Fig. 4 is a flow chart of channel region search operation in tuning control processing in Fig. 2.

Fig. 5 is a structural block diagram of tuning circuit in prior art.

Fig. 6 is a signal waveform diagram for explaining search operation common to the prior art and embodiment.

### DETAILED DESCRIPTION OF THE EMBODIMENT

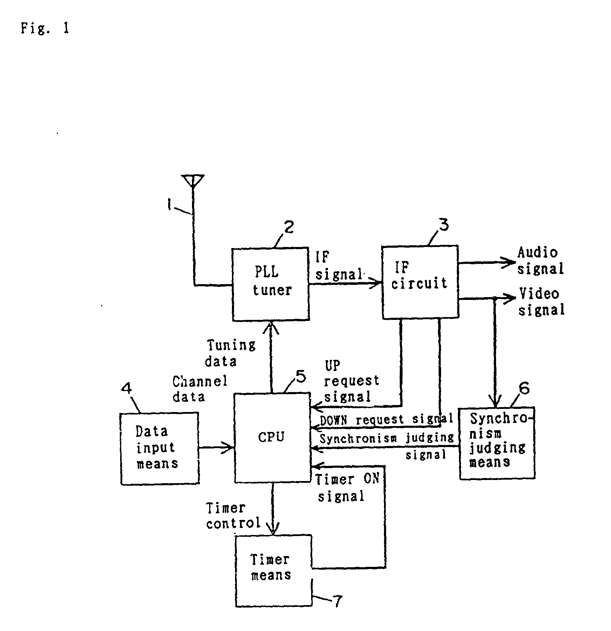

Referring now to the drawings, an embodiment of a tuning circuit according to the present invention is described below. Fig. 1 is a block diagram of a tuning circuit for a television broadcast receiving system using frequency synthesized channel selection.

In Fig. 1, a high frequency video signal received by a receiving antenna 1 is fed to a PLL tuner 2 incorporating a local oscillator circuit. In the PLL tuner 2, the local oscillator circuit generates a local oscillation frequency corresponding to the tuning data from a CPU 5 and the local oscillation signal is mixed with the received high frequency video signal, to generate an intermediate frequency signal at a frequency derived by subtracting the high frequency video signal frequency from the local oscillation frequency. The intermediate frequency signal is fed to an intermediate frequency circuit (IF circuit) 3.

In the IF circuit 3, by detecting a high frequency video signal of a channel of a specific frequency, a video signal and an audio signal are extracted. The IF circuit 3 incorporates an AFT circuit, and an AFT voltage is generated. An UP request signal and a DOWN request signal are created from the AFT voltage, and are supplied into the CPU 5. When tuning, the user enters data into the CPU 5 through a data input means 4 for selecting the channel and the like.

The UP request signal is to request an increase in the local oscillation frequency of the local oscillation circuit of the PLL tuner 2, and the DOWN request signal is to request a decrease in the local oscillation frequency.

A synchronism judging circuit 6 judges if a horizontal sync signal is contained or not in the detected video signal incoming from the IF circuit 3, and issues a synchronism judging signal to the CPU 5. A synchronism presence signal (L level) is sent out to the CPU 5 if the horizontal sync signal is present, and a synchronism absence signal (H level) if not.

Timer means 7 issues a timer ON signal during counting of a specific period of time under the control of the CPU 5.

The CPU 5 in the form of a microcomputer receives the UP request signal or the DOWN request signal from the IF circuit 3, the synchronism judging signal from the synchronism judging means 6, and the timer ON signal from the timer means 7, and sends out tuning data to the PLL tuner 2.

In the embodiment, the main difference from the construction of the prior art in Fig. 5 is that the timer means 7 is present in order to start counting the specific time immediately after channel selection is input so that the output of the timer ON signal (H signal) is fed into the CPU 5 while the timer means 7 is operating.

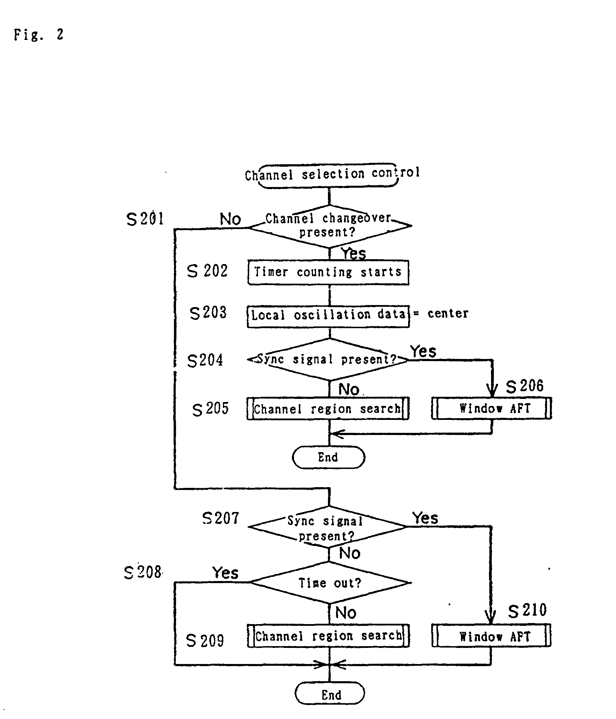

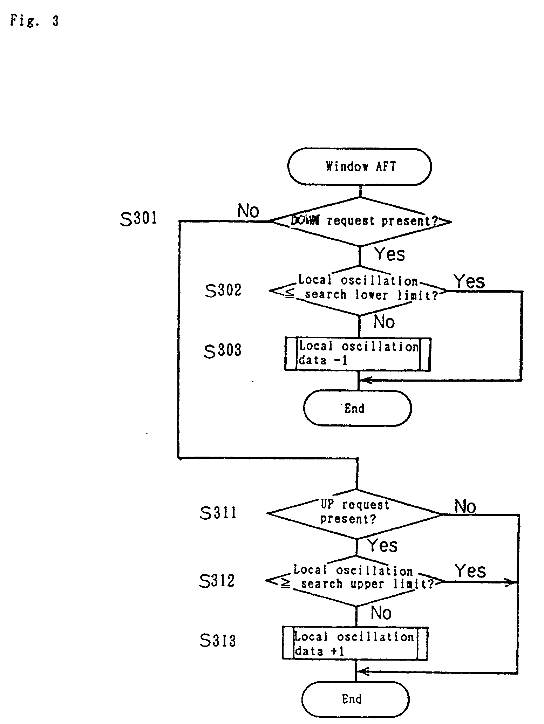

The operation of the invention is described below while referring to the flow charts in Fig. 2 and Fig. 3. Fig. 2 shows a channel selection control process, and Fig. 3 illustrates window AFT processing during the channel selection control process in Fig. 2. The channel selection control process in Fig. 2 is placed in the main loop of the CPU 5, and is executed every time in the main loop period (16 ms).

When the user enters channel changeover from the data input means 4 in Fig. 1, this request is judged at step S201 and processing advances to step S202, where the timer means 7 starts counting for a period of 800 ms. Consequently, at step S203, the local oscillation frequency data is set to the center value of the channel. If there is no channel changeover input, processing jumps to step S207.

At step S204, depending on the presence or absence of the synchronism judging signal from the synchronism judging circuit 6, it is judged if there is a sync signal in the received signal or not. If the synchronism judging signal is absent, channel region search processing at step S205 is executed and then processing is terminated. The channel search operation to be executed at step S205 is the same as in the flow chart in Fig. 4 described above.

When it is judged at step S204 that the synchronism judging signal is present, window AFT processing at step S206 is executed and the processing is terminated.

At step S207 it is judged if the synchronism judging signal is present or absent. If the synchronism judging signal is absent, it is judged at step S208 if the timer means 7 has timed out or not. If the synchronism judging signal is present, jumping to step S210, window AFT processing is executed and the processing is terminated.

If it is judged at step S208 that the timer means 7 has not timed out, channel region search processing is executed and the processing is terminated. The channel region search processing to be executed at step S209 is the same as in the flow chart in Fig. 4 described above. If, however, it is judged at step S208 that the timer means 7 is timed out, channel region search processing is not executed and no further processing is undertaken.

The window AFT processing in Fig. 3 is described below. The window AFT processing is the process for setting the local oscillation frequency data so that the AFT voltage may settle between REF1 and REF2 of the AFT voltage shown in Fig. 6.

In the flow chart in Fig. 3, step S301 is to judge the presence or absence of a DOWN request signal from the IF circuit 3.

If a DOWN request signal is present, step S302 is processed, and if absent, step S311 is processed.

Step S302 is to judge if the local oscillation frequency data is smaller than the lower limit of the channel or not. When the local oscillation frequency data is smaller than the lower limit of the channel, processing is over. If not smaller, processing moves to step S303, the local oscillation frequency data is lowered by one step, and processing is ended.

Step S311 is to judge the presence or absence of an UP request from the IF circuit 3. If there is no UP request signal, processing is ended. If present, processing moves to step S312 where it is judged if the local oscillation frequency data has exceeded the upper limit value of the channel or not. Processing is over if the upper limit value is exceeded. If not exceeded, the local oscillation frequency data is raised by one step, at step S313, and processing is then ended.

In the embodiment of the invention, for speedy processing of channel selection, the synchronism judging signal is checked by setting the local oscillation frequency data to the center value of the selected channel immediately after channel changeover, and the window AFT processing is done immediately if the synchronism judging signal is present.

Moreover, if not immediately after changeover of channel, the synchronism judging signal is always monitored upon every start of the main loop, of the CPU5, and when the synchronism judging signal is present, the window AFT operation is continued. If, after termination of processing immediately after channel changeover, the main loop is started and there is no channel changeover, synchronism judging signal is absent, and when the timer means 7 is in timer ON state, the channel search operation is executed again.

In this arrangement if the synchronism judging signal obtained in the process immediately after channel changeover is unstable and correct search processing is not done, the channel region search can be done once more.

In the embodiment, the value of 800 ms is set in the timer means 7, but various values may be used depending on the application, and the performance of channel search operation can be enhanced.

According to the invention, if a stable synchronism judging signal cannot be obtained from the synchronism judging circuit when selecting the channel, in case the synchronism judging signal is eliminated although searching is over by setting the optimum local oscillation frequency in the channel region search, the optimum local oscillation frequency can be set again by performing a channel region search again if the timer means 7 is in the process of counting, so that the performance of channel search is enhanced greatly.

Besides, the timer means 7 shown in Fig. 1 can be actually executed in the software of the CPU 5, and it is not necessary to add hardware. Enhanced effects are thus obtained without raising cost.

Incidentally, the time and data quantities mentioned in the embodiment are only examples, and these values are not limitative. The invention is not limited to this embodiment alone, and may be embodied by modification as will be apparent to those skilled in the art.

## Claims

1. A tuning circuit for use in a television receiver having a frequency synthesizing channel selector, the circuit comprising:
a PLL tuner (2) incorporating a local oscillation circuit,
an intermediate frequency circuit (3) incorporating an auto-fine tuning (AFT) circuit, for generating an UP request signal or a DOWN request signal corresponding to an AFT voltage,
data input means (4) for use by a user to select the channel,
synchronism judging means (6) for judging if there is a sync signal or not in the video signals of the output of the intermediate frequency circuit (3), and generating a synchronism judging signal,
timer means (7) for generating a timer ON signal only while counting within a specific period of time, and
control means (5) responsive to selection of a new channel for controlling a search operation within the channel frequency region by sending tuning data to the PLL tuner (2) and sending timer controlling signals to the timer means (7);
**characterized in that**;
the control means (5) starts up a tuning control main loop, which is executed repeatedly within the specific period of time, receiving an UP request signal or a DOWN request signal from the IF circuit (3), the synchronism judging signal from the synchronism judging means (6) and the timer ON signal from the timer means (7), and for sending tuning data to the PLL tuner (2) to perform a search operation within the channel frequency region, and
the control means (5) is arranged to monitor the synchronism judging signal from the synchronism judging means (6) upon every start of the main loop during the operation of the timer means (7), and performs a search operation within the channel frequency region when the synchronism judging signal is absent during the presence of the timer ON signal.

2. A tuning circuit of Claim 1, wherein the control means (3) is arranged to initiate counting of the specific period of time by the timer means (7) immediately after changeover of channel selection, monitor the synchronism judging signal from the synchronism judging means upon every start of main loop during counting of the timer means, and perform window AFT processing if there is synchronism judging signal during presence of the timer ON signal.

3. A tuning circuit of Claim 1 or 2, wherein the control means (3) is arranged to check the synchronism judging signal by setting the local oscillation frequency data to the center value of the selected channel immediately after channel changeover, and perform window AFT processing immediately if the synchronism judging signal is found.

4. A tuning circuit of Claim 1, 2 or 3, wherein the control means (3) is arranged to check the synchronism judging signal by setting the local oscillation frequency data to the center value of the selected channel immediately after channel changeover, and performs the channel region search processing immediately if the synchronism judging signal is not found.

## Patentansprüche

1. Abstimmungsschaltung zum Einsatz in einem Fernsehempfänger mit einem Frequenzsynthese-Kanalwähler, wobei die Schaltung umfasst:
einen PLL-Tuner (2), der eine Empfangsoszillationsschaltung enthält,
eine Zwischenfrequenzschaltung (3), die eine automatische Scharfabstimmungsschaltung (AFT) enthält und ein AUFWÄRTS-Anforderungssignal oder ein ABWÄRTS-Anforderungssignal entsprechend einer AFT-Spannung erzeugt,
eine Dateneingabeeinrichtung (4), die von einem Benutzer verwendet wird, um den Kanal zu wählen,
eine Synchronismus-Feststelleinrichtung (6), die feststellt, ob ein Synchronsignal in den Videosignalen des Ausgangs der Zwischenfrequenzschaltung (3) vorhanden ist oder nicht und ein Synchronismus-Feststelisignal erzeugt;
eine Zeitsteuerungseinrichtung (7), die ein Zeitsteuerungseinrichtungs-AN-Signal nur während des Zählens innerhalb eines speziellen Zeitraums erzeugt, und
eine Steuereinrichtung (5), die auf die Wahl eines neuen Kanals anspricht und einen Suchvorgang innerhalb des Kanalfrequenzbereiches steuert, indem sie Abstimmungsdaten zu dem PLL-Tuner (2) sendet und Zeitsteuerungseinrichtungs-Steuersignale zu der Zeitsteuerungseinrichtung (7) sendet;
**dadurch gekennzeichnet, dass**:
die Steuereinrichtung (5) eine Abstimmungssteuerungs-Hauptschleife in Gang setzt, die wiederholt innerhalb des speziellen Zeitraums ausgeführt wird, ein AUFWÄRTS-Anforderungssignal oder ein ABWÄRTS-Anforderungssignal von der Zwischenfrequenzschaltung (3), das Synchronismus-Feststellsignal von der Synchronismus-Feststelleinrichtung (6) und das Zeitsteuerungseinrichtungs-AN-Signal von der Zeitsteuerungseinrichtung (7) empfängt und Abstimmungsdaten zu dem PLL-Tuner (2) sendet, um einen Suchvorgang innerhalb des Kanalfrequenzbereiches auszuführen, und
die Steuereinrichtung (5) das Synchronlsmus-Feststeiisignal von der Synchronismus-Feststelleinrichtung (6) bei jedem Ingangsetzen der Hauptschleife während der Funktion der Zeitsteuerungseinrichtung (7) überwacht und einen Suchvorgang innerhalb des Kanalfrequenzbereiches ausführt, wenn das Synchronismus-Feststellsignal während des Vorhandenseins des Zeitsteuerungseinrichtungs-AN-Signals nicht vorhanden ist.

2. Abstimmungsschaltung nach Anspruch 1, wobei die Steuereinrichtung (3) das Zählen des speziellen Zeitraums durch die Zeitsteuerungseinrichtung (7) unmittelbar nach dem Wechsel der Kanalwahl auslöst, das Synchronismus-Feststellsignal von der Synchronismus-Feststelleinrichtung bei jedem Ingangsetzen der Hauptschleife während des Zählens der Zeitsteuerungseinrichtung überwacht und Fenster-AFT-Verarbeitung ausführt, wenn während des Vorhandenseins des Zeltsteuerungseinrichtungs-AN-Signals ein Synchronlsmus-Feststellsignal vorhanden ist.

3. Abstimmungsschaltung nach Anspruch 1 oder 2, wobei die Steuereinrichtung (3) das Synchronismus-Feststeiisignal prüft, indem sie die Empfangsoszillations-Frequenzdaten auf den Mittenwert des ausgewählten Kanals unmittelbar nach dem Kanalwechsel einstellt und Fenster-AFT-Verarbeitung unmittelbar dann ausführt, wenn das Synchronlsmus-Feststellslgnal gefunden wird.

4. Abstimmungsschaltung nach Anspruch 1, 2 oder 3, wobei die Steuereinrichtung (3) das Synchronismus-Feststellsignal prüft, indem sie die Empfangsoszillations-Frequenzdaten auf den Mittenwert des ausgewählten Kanals unmittelbar nach dem Kanalwechsel einstellt, und die Kanaibereichs-Suchverarbeitung unmittelbar dann ausführt, wenn das Synchronlsmus-Feststellsignal nicht gefunden wird.

## Revendications

1. Circuit d'accord destiné à être utilisé dans un récepteur de télévision possédant un sélecteur de canal à synthèse de fréquences, le circuit comprenant :
un organe d'accord (2) à boucle à verrouillage de phase (PLL) comprenant un circuit local d'oscillation,
un circuit (3) à fréquence intermédiaire comprenant un circuit de réglage fin automatique (AFT) destiné à créer un signal de requête UP ou un signal de requête DOWN correspondant à une tension AFT,
un dispositif (4) de saisie de données destiné à être utilisé par un utilisateur pour la sélection du canal,
un dispositif (6) de jugement de synchronisme destiné à déterminer s'il existe ou non un signal de synchronisation dans les signaux vidéo de la sortie du circuit (3) à fréquence intermédiaire, et à créer un signal de jugement de synchronisme,
un dispositif à minuterie (7) destiné à créer un signal de présence de minuterie uniquement lors du comptage dans une période spécifique, et
un dispositif de commande (5) commandé par la sélection d'un nouveau canal pour la commande d'une opération de recherche dans la région de fréquences des canaux par transmission de données d'accord à l'organe d'accord (2) à boucle à verrouillage de phase et par émission de signaux de commande de minuterie au dispositif à minuterie (7),
**caractérisé en ce que**
le dispositif de commande (5) lance une boucle principale de réglage d'accord qui est exécutée de façon répétée dans la période spécifique, à la réception d'un signal de requête UP ou d'un signal de requête DOWN du circuit à fréquence intermédiaire (3), du signal de jugement de synchronisme provenant du dispositif (6) de jugement de synchronisme et du signal de présence de minuterie provenant du dispositif à minuterie (7), pour émettre des données de réglage à l'organe d'accord (2) à boucle à verrouillage de phase pour l'exécution d'une opération de recherche dans la région de fréquences de canal, et
le dispositif de commande (5) est destiné à contrôler le signal de jugement de synchronisme provenant du dispositif (6) de jugement de synchronisme à chaque lancement de la boucle principale lors du fonctionnement du dispositif à minuterie (7), et exécute une opération de recherche dans la région de fréquences de canal lorsque le signal de jugement de synchronisme est absent en présence du signal de présence de minuterie.

2. Circuit d'accord selon la revendication 1, dans lequel le dispositif de commande (3) est destiné à lancer le comptage de la période spécifique par le dispositif à minuterie (7) immédiatement après la commutation de la sélection d'un canal, à contrôler le signal de jugement de synchronisme provenant du dispositif de jugement de synchronisme à chaque lancement de la boucle principale pendant le comptage du dispositif à minuterie, et à exécuter un traitement AFT de fenêtre lorsqu'il existe un signal de jugement de synchronisme en présence du signal de présence de minuterie.

3. Circuit d'accord selon la revendication 1 ou 2, dans lequel le dispositif de commande (3) est destiné à vérifier le signal de jugement de synchronisme par établissement des données de la fréquence d'oscillation locale à la valeur centrale du canal sélectionné juste après la commutation de canal, et à exécuter un traitement AFT de fenêtre immédiatement lorsque le signal de jugement de synchronisme est trouvé.

4. Circuit d'accord selon la revendication 1, 2 ou 3, dans lequel le dispositif de commande (3) est destiné à vérifier le signal de jugement de synchronisme par établissement des données de fréquence d'oscillation locale à la valeur centrale du canal sélectionné immédiatement après la commutation du canal, et à exécuter le traitement de recherche de la région de canal immédiatement lorsque le signal du jugement de synchronisme n'est pas trouvé.
